# EUROPÄISCHE PATENTANMELDUNG

(11) **EP 1 089 332 A2**
(43) Veröffentlichungstag der Anmeldung: **04.04.2001**
(21) Anmeldenummer: 00118594.1
(22) Anmeldetag: 28.08.2000
(51) Int. Cl.: H01L 21/8247, H01L 21/8238

(54) **Verfahren zur Herstellung eines integrierten CMOS-Halbleiterspeichers**

(30) Priorität: 30.09.1999 DE 19946883
(71) Anmelder: Micronas GmbH, 79108 Freiburg (DE)
(72) Erfinder: Frerichs, Heinz-Peter, Dr., 79271 St. Peter (DE); Zimmer, Hans-Günter, Dr., 79276 Reute (DE)
(74) Vertreter: Patentanwälte Westphal, Mussgnug & Partner

(57) **Zusammenfassung**

Es wird ein Verfahren zur Herstellung eines integrierten, nichtflüchtigen CMOS-Halbleiterspeichers mit mindestens einer eingebetteten EEPROM / EPROM -Struktur beschrieben, das sich insbesondere dadurch auszeichnet, daß die EEPROM / EPROM - Struktur aus einer Mehrzahl von Speicherzellen aufgebaut wird, die jeweils aus einem Zugriffstransistor und einem Floating-Gate Transistor erzeugt werden, wobei anschließend auf das Floating-Gate (6) eine erste dielektrische Schicht (11) aufgebracht wird, auf der dann eine Schicht zur Erzeugung einer für alle Speicherzellen gemeinsamen Gate-Kapazität (7) in der Weise aufgebracht wird, daß eine zur Programmierung des Floating-Gate Transistors erforderliche Potentialanhebung auf kapazitive Weise durch Anlegen einer für alle Speicherzellen gemeinsamen Spannung erzielt werden kann.

## Beschreibung

Die Erfindung betrifft ein Verfahren zur Herstellung eines integrierten, nichtflüchtigen CMOS-Halbleiterspeichers mit mindestens einer eingebetteten EEPROM- oder EPROM- (Electrically / Erasable and Programmable Read-Only Memory) -Struktur (embedded EEPROM / EPROM), gemäß dem Oberbegriff von Anspruch 1.

EEPROM / EPROM-Strukturen dienen zum Aufbau von nichtflüchtigen Halbleiterspeichern insbesondere für integrierte Schaltungen, die allgemein zur Anwendung in Computern oder in mikroprozessorgesteuerten Vorrichtungen zur Speicherung von Programmen und / oder Daten dienen, die auch ohne Versorgungsspannung erhalten bleiben sollen.

Jede Speicherzelle einer EEPROM / EPROM-Struktur weist im allgemeinen zwei Transistoren auf, nämlich einen Auswahl- oder Zugriffstransistor, mit dem die betreffende Speicherzelle ausgewählt wird, sowie einen Floating-Gate Transistor, dessen Floating-Gate durch entsprechende positive oder negative Aufladung einen gelöschten bzw. programmierten Zustand darstellt.

Zum Programmieren und Löschen der Speicherzellen sind in der Regel Spannungen von mindestens 8 Volt auf Zellenebene und somit Spannungen von etwa 10 Volt für die Pass-Gates erforderlich. Diese Spannungen müssen bei den bekannten EEPROM / EPROM-Strukturen selektiv an jede zu programmierende oder zu löschende Speicherzelle angelegt werden. Dies bedeutet, daß Transistoren vorhanden sein müssen, die diese Spannungen schalten können. Da jede Speicherzelle selektiert werden muß, müssen die Transistoren außerdem hinreichend klein sein, damit die gesamte Struktur und somit der Speicher nicht unverhältnismäßig groß werden.

Ein Problem hierbei besteht darin, daß die üblicherweise hergestellten integrierten CMOS-Schaltungen sowie ihre Herstellungsverfahren für 5 Volt oder weniger ausgelegt sind. Um die zur Einbettung von EEPROM/EPROM-Strukturen notwendigen hohen Spannungen mit einem üblichen CMOS-Herstellungsverfahren für integrierte Schaltungen handhaben zu können, sind in der Regel zahlreiche zusätzliche Prozeßschritte (im allgemeinen etwa fünf bis acht Maskenschritte) erforderlich, die den gesamten Prozeß und damit auch die integrierte Schaltung erheblich verteuern.

Der Erfindung liegt deshalb die Aufgabe zugrunde, ein Verfahren zur Herstellung eines integrierten, nichtflüchtigen CMOS-Halbleiterspeichers der eingangs genannten Art zu schaffen, mit dem mit relativ geringem Aufwand eine Einbettung mindestens einer EEPROM / EPROM-Struktur möglich ist.

Gelöst wird diese Aufgabe gemäß Anspruch 1 mit einem Verfahren der eingangs genannten Art, das sich dadurch auszeichnet, daß die EEPROM / EPROM - Struktur aus einer Mehrzahl von Speicherzellen aufgebaut wird, die jeweils aus einem Zugriffstransistor und einem Floating-Gate Transistor erzeugt werden, wobei anschließend auf das Floating-Gate eine erste dielektrische Schicht aufgebracht wird, auf der dann eine Schicht zur Erzeugung einer für alle Speicherzellen gemeinsamen Gate-Kapazität in der Weise aufgebracht wird, daß eine zur Programmierung des Floating-Gate Transistors erforderliche Potentialanhebung auf kapazitive Weise durch Anlegen einer für alle Speicherzellen gemeinsamen Spannung erzielt werden kann.

Ein besonderer Vorteil dieses Verfahrens besteht darin, daß die Standard-Transistoren während des Verfahrensablaufes nicht durch zusätzliche Prozeßschritte hinsichtlich ihrer elektrischen Parameter verändert werden, und daß nur ein zusätzlicher Maskenschritt erforderlich ist. Außerdem bleiben beim Ätzen der zusätzlichen gemeinsamen Gate-Kapazität keine unerwünschten Reste zurück.

Die zusätzlichen Gate-Kapazitäten verleihen dem Halbleiterspeicher weitere wesentliche Vorteile. Diese ergeben sich daraus, daß die zum Programmieren und Löschen der Speicherzellen erforderliche Potentialanhebung auf kapazitivem Wege durch Anlegen einer für alle Zellen gemeinsamen Spannung an diese Gate-Kapazitäten erzielt werden kann. Diese Spannung muß somit nicht dekodiert werden. Folglich müssen auch keine Hochspannungstransistoren erzeugt werden, die andere Gateoxid-Dicken und Diffusionen erfordern würden. Hierdurch werden bei der Herstellung weitere zahlreiche Masken- und Prozeßschritte eingespart, was ebenfalls dazu beiträgt, daß die elektrischen Parameter der Standard-Transistoren im wesentlichen unverändert bleiben. An die zusätzlichen Gate-Kapazitäten können hingegen auch Spannung mit mehr als 20 Volt angelegt werden, da diese nicht geschaltet werden müssen.

Die Unteransprüche haben vorteilhafte Weiterbildungen der Erfindung zum Inhalt.

Danach kann zur Erzeugung der Gate-Kapazität alternativ eine Siliziumnitridschicht mit einer Dicke von etwa 30 nm, eine Polylage mit einer Dicke von etwa 50 nm, oder eine Titan- / Titannitrid-Schicht mit einer Dicke von etwa 30 nm aufgebracht werden.

Weitere Einzelheiten, Merkmale und Vorteile der Erfindung ergeben sich aus der folgenden Beschreibung einer bevorzugten Ausführungsform anhand der Zeichnung. Es zeigt:
- Fig. 1: einen Querschnitt durch einen Teil einer mit einem erfindungsgemäßen Verfahren hergestellten EEPROM / EPROM-Speicherzelle; und
- Fig. 2 bis 5: Darstellungen verschiedener Prozeßschritte während eines erfindungsgemäßen Verfahrens.

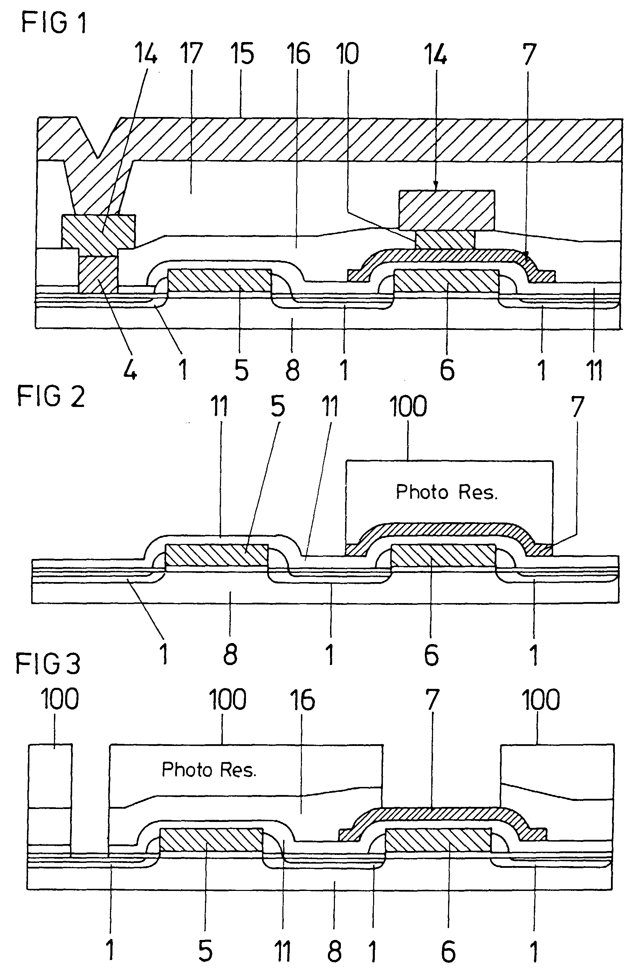

Figur 1 zeigt als Teil einer bevorzugten EEPROM / EPROM-Struktur, die in eine integrierte CMOS-Schaltung eingebettet sein kann, einen Querschnitt durch eine Speicherzelle mit einem Floating-Gate Transistor und einem Zugriffstransistor (2-Transistor-Zelle). In ein p-Substrat 8 sind n-dotierten Diffusionsschichten 1 durch Implantation eingebracht. Auf dem p-Substrat befindet sich ein erster Metallkontakt 4, ein Gate 5 des Zugriffstransistors (erste Polyschicht), sowie ein Floating-Gate 6 des Floating-Gate Transistors (zweite Polyschicht). Auf dem Gate 5 sowie dem Floating-Gate 6 befindet sich eine erste diektrische Schicht 11, die eine zusätzliche, gemeinsame Gate-Kapazität 7 im Bereich des Floating-Gates 6 trägt und diese von dem Floating-Gate isoliert. Die Gate-Kapazität 7 dient gleichzeitig als Ätzstop und kann eine Siliziumnitridschicht, eine dünne Polylage oder eine dünne Titan / Titannitrid (Ti/TiN) Schicht sein.

Auf diese Lagen wird eine zweite dielektrische Schicht 16 aufgebracht, in die mit bekannten fotolithographischen Verfahren Löcher für den ersten Metallkontakt 4 und einen zweiten Metallkontakt 10 für die gemeinsame Gate-Kapazität 7 eingeätzt werden. Zur Erzeugung dieser Kontakte werden die Löcher mittels einer bekannten Plug-Technologie mit Metall gefüllt. Zur Kontaktierung wird darauf jeweils eine erste Metalllage 14 aufgebracht. Auf diesen Lagen wird eine dritte dielektrische Schicht 17 erzeugt, in die zur Kontaktierung mit der ersten Metalllage 14 entsprechende Löcher eingeätzt werden. Schließlich werden die Löcher mit Metall gefüllt und die dritte dielektrische Schicht 17 mit einer zweite Metalllage 15 abgedeckt.

Bei der beschriebenen erfindungsgemäßen Ausführungsform ist die EPROM-Speicherzelle eine 2-Transistor-Zelle mit einem Floating-Gate Transistor in Form eines Depletion n-Kanal Transistors, wobei die zur Programmierung erforderliche Potentialanhebung durch Anlegen einer Spannung an die gemeinsame Gate-Kapazität vorgenommen wird. Dies geschieht über eine Programmierleitung, wobei die Spannung zwischen etwa 10 und 30 Volt liegt. Die Höhe ist von der Stärke der ersten dielektrischen Schicht 11 zwischen der gemeinsamen Gate-Kapazität 7 und dem Floating-Gate 6 abhängig. Die einzelne Speicherzelle wird dabei über eine der Zugriffsleitungen und über eine der Bitleitungen adressiert. Die adressierte Zelle weist eine Drain-Spannung von Vdd und eine Source-Spannung auf, die über eine entsprechende Sourceleitung angelegt wird. Die an der Drain-Seite erzeugten heißen Elektronen werden durch das hohe positive Potential an der gemeinsamen Gate-Kapazität, das über die Programmierleitung angelegt wird, auf das Floating-Gate 6 gezogen. Dieses lädt sich dadurch negativ auf, so daß der Floating-Gate Transistor in den "Aus-" Zustand gelangt.

Zum Lesen einer Speicherzelle wird an die Programmierleitung eine Spannung Vss bzw. 0 Volt angelegt. Die betreffende Zelle wird wieder über eine der Bitleitungen und eine der Zugriffsleitungen adressiert und auf Stromfluß detektiert. Wenn das Floating-Gate 6 nicht geladen ist, so fließt ein Strom (Signal "1") ' wenn es hingegen negativ geladen ist, fließt kein Strom (Signal "0").

Zum Löschen werden die EPROM-Speicherzellen einem UV-Licht ausgesetzt, so daß die Ladungen auf den Floating-Gates beseitigt werden. Da die Floating-Gate Transistoren Depletion n-Kanal Transistoren sind, wird dadurch der Zustand "Ein" eingenommen, wobei ein Strom fließt und ein Signalwert "1" gelesen wird. Im Falle von EEPROM-Zellen erfolgt das Löschen aller Speicherzellen (alle Bitleitungen haben 0 Volt) über einen Fowler-Nordheim Tunnelstrom durch Anlegen einer Spannung von etwa 12 Volt an die Injektionsleitungen, während die übrigen Gates und Leitungen auf etwa 0 Volt bleiben.

Im folgenden sollen anhand der Figuren 2 bis 5 verschiedene Herstellungsschritte für diese Struktur sowie Alternativen dafür im Detail beschrieben werden. Das Verfahren eignet sich insbesondere zur Herstellung von 2-Transistorzellen mit EEPROM / EPROM-Transistoren, die einen Depletion n-Kanal Transistor aufweisen und bei denen die zur Programmierung erforderliche Potentialanhebung auf kapazitive Weise durch die zusätzliche gemeinsame Gate-Kapazität vorgenommen wird. Das Verfahren eignet sich jedoch auch zur Herstellung von integrierten Schaltungen mit anderen, allgemein bekannten EEPROM- oder EPROM-Zellen.

Gemäß Figur 2 werden auf einem p-Substrat 8 zunächst ein Gate 5 eines Zugriffstransistors sowie ein Floating-Gate 5 eines Floating-Gate Transistors erzeugt und durch Implantation n-dotierte Diffusionensschichten 1 in das p-Substrat 8 eingebracht. Auf diese Struktur wird dann eine erste dielektrische Schicht 11 aufgebracht, die ein Oxinitrid oder ein Oxid mit einer Schichtdicke von etwa 30 nm sein kann. Darauf wird dann alternativ entweder eine Siliziumnitridschicht mit einer Dicke von etwa 30 nm, eine Polylage mit einer Dikke von etwa 50 nm oder eine Ti/TiN Schicht mit einer Dicke von etwa 30 nm aufgetragen. Nach dem Ätzen der Source / Dram-Bereiche oder einer POCL-Dotierung wird dann eine lichtempfindliche Schicht 100 aufgetragen und so maskiert, daß nach dem Belichten und Ätzen im Bereich des Floating-Gates 6 die gemeinsame Gate-Kapazität 7 zurückbleibt und die in Figur 2 gezeigte Struktur entsteht.

Die Herstellung wird in bekannter Weise durch Aufbringen der zweiten dielektrischen Schicht 16 sowie erneutes Auftragen einer lichtempfindlichen Schicht 100, Maskieren, Belichten und Kontaktätzen fortgesetzt, wobei die Gate-Kapazität 7 als Ätzstop dient, bis die in Figur 3 gezeigte Struktur entstanden ist.

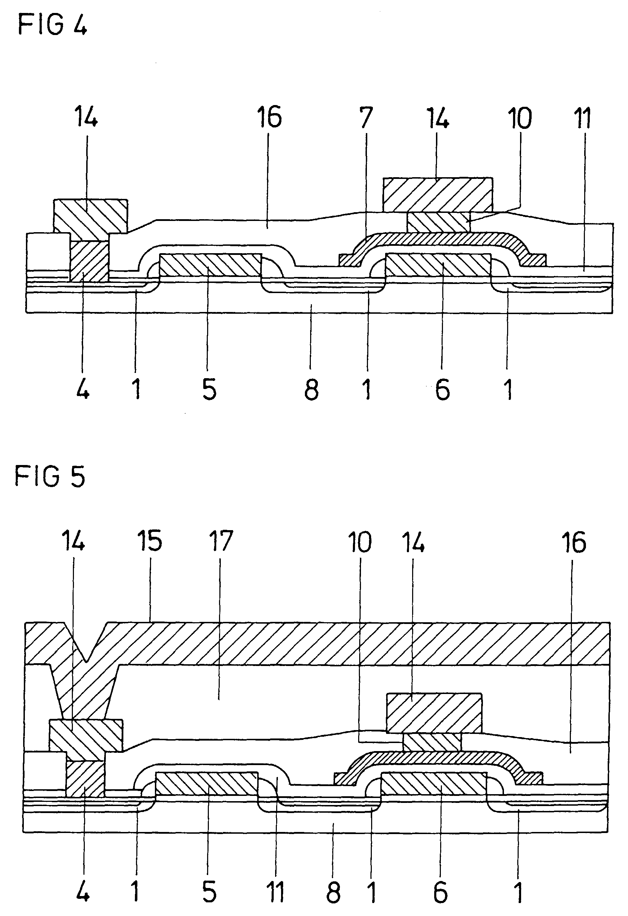

Nach dem Entfernen der lichtempfindlichen Schicht 100 folgt gemäß Figur 4 das Einbringen von Metall-, insbesondere Wolfram-Plugs in die für den ersten und zweiten Kontakt 4, 10 geätzten Löcher. Anschließend wird die erste Metalllage 14 aufgebracht und in bekannter Weise mit einer lichtempfindlichen Schicht abgedeckt, maskiert, belichtet und geätzt, so daß über dem Metall des ersten und zweiten Kontaktes 4, 10 entsprechende Kontaktierungen erzeugt werden und die in Figur 4 gezeigte Struktur entsteht.

Auf diese Struktur wird dann die dritte dielektrische Schicht 17 aufgebracht und zur Kontaktierung mit der ersten Metalllage 14 an den entsprechenden Stellen geätzt, indem wiederum in bekannte Weise eine lichtempfindlichen Schicht aufgebracht und diese maskiert und belichtet wird. Die eigentliche Kontaktierung erfolgt dann durch Aufbringen der zweiten Metalllage 15 auf die dritte dielektrische Schicht 17 sowie Auffüllen der geätzten Löcher mit diesem Metall, so daß die in Figur 5 gezeigte Struktur entsteht.

Ein wesentliches Merkmal des erfindungsgemäßen Verfahrens besteht somit darin, daß die gemeinsame Gate-Kapazität 7 erst nach der Realisierung der Standard-Transistoren hergestellt wird. Diese Gate-Kapazität wird vorzugsweise entweder durch einen Metall-Plug oder durch eine dünne Lage aus Polysilizium oder Titan/Titannitrid definiert, die von den anderen Strukturen durch Ätzen entfernt werden kann, ohne daß sogenannte "Spacer" zurückbleiben. Die niederohmige Verbindung der Kapazitätsschicht wird durch die erste Metalllage erreicht.

## Patentansprüche

1. Verfahren zur Herstellung eines integrierten, nichtflüchtigen CMOS-Halbleiterspeichers mit mindestens einer eingebetteten EEPROM / EPROM -Struktur,
**dadurch gekennzeichnet, daß**
die EEPROM / EPROM - Struktur aus einer Mehrzahl von Speicherzellen aufgebaut wird, die jeweils aus einem Zugriffstransistor und einem Floating-Gate Transistor erzeugt werden, wobei anschließend auf das Floating-Gate (6) eine erste dielektrische Schicht (11) aufgebracht wird, auf der dann eine Schicht zur Erzeugung einer für alle Speicherzellen gemeinsamen Gate-Kapazität (7) in der Weise aufgebracht wird, daß eine zur Programmierung des Floating-Gate Transistors erforderliche Potentialanhebung auf kapazitive Weise durch Anlegen einer für alle Speicherzellen gemeinsamen Spannung erzielt werden kann.

2. Verfahren nach Anspruch 1,
**dadurch gekennzeichnet, daß**
zur Erzeugung der Gate-Kapazität (7) eine Siliziumnitridschicht mit einer Dicke von etwa 30 nm aufgebracht wird.

3. Verfahren nach Anspruch 1,
**dadurch gekennzeichnet, daß**
zur Erzeugung der Gate-Kapazität (7) eine Polylage mit einer Dicke von etwa 50 nm aufgebracht wird.

4. Verfahren nach Anspruch 1,
**dadurch gekennzeichnet, daß**
zur Erzeugung der Gate-Kapazität (7) eine Titan- / Titannitrid-Schicht mit einer Dicke von etwa 30 nm aufgebracht wird.

5. Verfahren nach Anspruch 1,
**dadurch gekennzeichnet, daß**
der Floating-Gate Transistor in Form eines Depletion n-Kanal Transistors realisiert wird.
